Europäisches Patentamt

European Patent Office

Office européen des brevets

(11) Publication number: **0 260 360 B1**

# EUROPEAN PATENT SPECIFICATION

(45) Date of publication of patent specification: **11.03.92** (51) Int. Cl.<sup>5</sup>: **H01L 23/28**, H01L 23/29, H01L 23/31

(21) Application number: **86307211.2**

(22) Date of filing: **19.09.86**

The file contains technical information submitted after the application was filed and not included in this specification

(54) **Resin-sealed semiconductor device.**

(43) Date of publication of application:
**23.03.88 Bulletin 88/12**

(45) Publication of the grant of the patent:
**11.03.92 Bulletin 92/11**

(84) Designated Contracting States:
**DE FR GB**

(56) References cited:
**EP-A- 0 108 502**
**EP-A- 0 124 624**
**EP-A- 0 239 315**
**DE-A- 1 904 786**
**DE-A- 2 922 005**

**PATENT ABSTRACTS OF JAPAN, vol. 8, no. 285 (E-287)[1722], 26th December 1984; & JP - A - 59 152 651**

(73) Proprietor: **DOW CORNING TORAY SILICONE CO., LTD.**
**3-16, Nihonbashi-muromachi 2-chome**
**Chuo-ku Tokyo(JP)**

(72) Inventor: **Mine, Katsutoshi**
**7-20-2, Aobadai**
**Ichihara-shi Chiba Prefecture(JP)**
Inventor: **Nakayoshi, Kazumi**
**1-6, Nishi Yusyudai**
**Ichihara-shi Chiba Prefecture(JP)**

(74) Representative: **Laredo, Jack Joseph et al**
**Elkington & Fife Prospect House 8 Pembroke Road**
**Sevenoaks, Kent TN13 1XR(GB)**

## Description

Background of the Invention

The present invention relates to a resin-sealed semiconductor device, and particularly to a resin-sealed semiconductor device having a semiconductor chip having thereon bonding pads electrically connected with a lead frame by bonding wires and having a surface thereof covered with a cured silicone film.

With a view to preventing deterioration or corrosion of the surface portion of a semiconductor chip by oxidation with the aid of moisture, and/or to relaxing the stress set up by expansion or shrinkage of a sealing resin caused by a temperature change for minimizing the influence of the stress on the semiconductor chip, the surface of a semiconductor chip has heretofore been covered with a cured silicone film formed from, for example, a silicone resin, a silicone rubber, or a silicone gel.

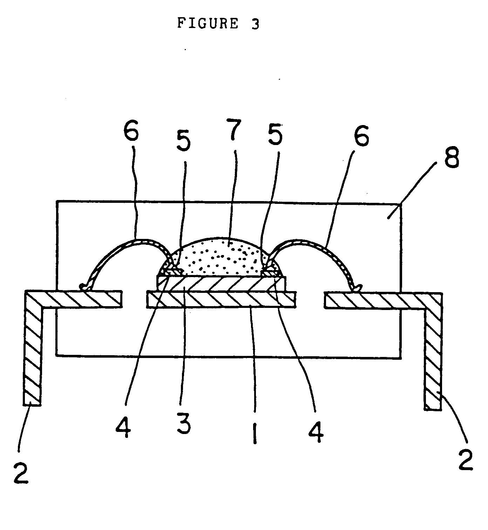

Fig. 3 is a cross-sectional view of such a conventional resin-sealed semiconductor device, which includes an island portion 1 and terminals 2 of a lead frame, a semiconductor chip 3 mounted and fixed on the island portion 1, bonding pads 4 consisting of thin aluminum films and formed on the semiconductor chip 3, and bonding wires 6 consisting of gold wires and electrically connecting the terminals 2 of the lead frame with the bonding pads 4 on the semiconductor chip 3. In this case, since bonding is made by the nailhead bonding method, nailheads 5 are formed on the bonding pads 4. A cured silicone film 7 serves to prevent external moisture from permeating into the semiconductor chip 4 and to relax the stress set up by expansion or shrinkage of the sealing resin 8 for minimizing the influence of the stress on the semiconductor chip 4.

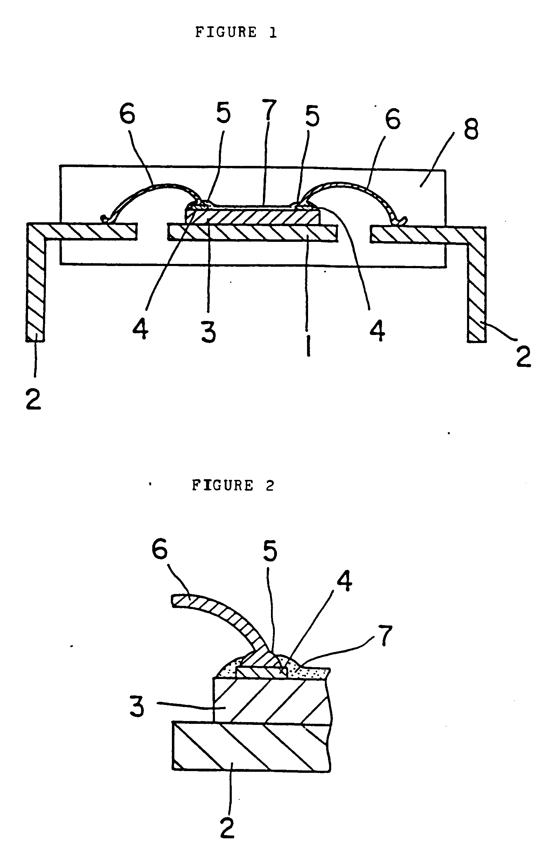

Such a device is also shown in the EP-A-0 124 624 (see Figure 1).

As shown in Fig. 3, the conventional resin-sealed semiconductor device has a relatively thick cured silicone film generally having a thickness of 100 to 500 $\mu$m. Therefore, not only the nailhead portions 5 on the bonding pads but also parts of the bonding wires 6 extending from the nailheads 5 are embedded in the cured silicone film 7. This has presented a problem that the bonding wires 6 tend to be broken in the course of sealing the semiconductor chip, the bonding wires, the lead frame, etc. with a thermosetting resin 8 such as an epoxy resin, or in the course of a thermal cycle test or a thermal shock test.

The trend of surface mounting for the purpose of materializing high density mounting on a printed circuit board has recently been developing. This has been increasingly presenting a problem that the bonding wires 6 tend to be broken when a thermal shock is inflicted on the above-mentioned conventional resin-sealed semiconductor device in the course of mounting the same on a printed circuit board, which course involves the procedure of immersion of the semiconductor device in a high temperature solder bath of about 260 °C and picking up the immersed device, followed by cooling. The bonding wire breaking is believed to be caused by a stress set up in a boundary between the thermoset resin 8 and the cured silicone film 7 owing to a difference in thermal expansion coefficient therebetween during the course of rapid expansion or shrinkage of the thermoset resin 8 and the cured silicone film 7 induced by the thermal shock in the sealing and/or mounting procedure.

Summary of the Invention

An object of the present invention is to provide a resin-sealed semiconductor device comprising a semiconductor chip having thereon bonding pads electrically connected with a lead frame by bonding wires and having a surface thereof covered with a cured silicone film, which device is improved in that bonding wire breaking caused by stress set up upon infliction of a thermal shock on the device is prevented to eliminate the adverse effect of the stress on the semiconductor device.

The structure of the resin-sealed semiconductor device of the present invention, which comprises a semiconductor chip having thereon bonding pads electrically connected with a lead frame by bonding wires and having a surface with a cured silicone film, is characterized by the fact that said cured silicone film is composed of a cured silicone rubber or a cured silicone gel, that said film has a thickness of 10 $\mu$m or less, and that said film integratedly covers only asid surface of said semiconducter chip, said bonding pads and the nailhead portions of said bonding wires.

According to the present invention, since the cured silicone film is formed in such a way that it covers the surface of the semiconductor chip together with the surface of the bonding pads and the nailhead portions of the bonding wires, bonding wire breaking caused by stress set up upon infliction of a thermal shock on the device can be prevented since the stress on the bonding wire is minimized by the above-mentioned structure. Further, since the surface of the semiconductor chip is covered with the cured silicone film, not only can the surface portion of the semiconductor chip be prevented from undergoing deterioration or corrosion owing to moisture infiltrating thereinto from the outside, but also the stress set up by expansion or shrinkage of the sealing resin upon a temperature change can be relaxed to minimize the influence thereof on the semiconductor chip, whereby peeling of a circuit pattern and/or separation of bonded nailheads from the pads can be prevented. Furthermore, formation of the thin cured silicone film allows the present invention to apply to a thin semiconductor device. Since a thin semiconductor device having a thin cured silicone film involves a smaller stress than that involved in a conventional counterpart device, cracking in a protective film provided on the semiconductor chip surface and made of, for example, phosphorus glass can be prevented, thus providing excellent moisture resistance. This enables the surface mounting process to be adapted for attaining high density mounting on a printed circuit board.

Brief Description of the Drawings

Fig. 1 is a cross-sectional view of a resin-sealed semiconductor device according to the present invention. Fig. 2 is a partially enlarged diagram of the proximity of a bonding pad. Fig. 3 is a cross-sectional view of a conventional resin-sealed semiconductor device.

Detailed Description of the Invention

An example according to the present invention will now be described with reference to the accompanying drawings.

Fig. 1 is a cross-sectional view of a resin-sealed semiconductor device according to the present invention including an island portion 1 and terminals 2 of a lead frame, and an LSI semiconductor chip 3 mounted and fixed on the island portion 1. A transistor, IC, or VLSI semiconductor chip may, of course, be mounted instead. Although a number of circuit elements such as transistors and resistances are normally formed on the semiconductor chip they have been omitted from the drawings in order to avoid unnecessary complication.

Bonding pads 4 are formed on the semiconductor chip 3, and consist of a thin aluminum film formed by the vacuum evaporation and deposition technique. Bonding wires 6 are of gold (aluminum is also usable). The bonding wires 6 have nailhead portions 5. A cured silicone film 7 is made of silicone rubber in this example, but may be made of silicone gel instead. The cured silicone film 7, which has a thickness of about 8 $\mu$m, integratedly covers a surface of the semiconductor chip 3, surfaces of the bonding pads, and parts of the nailheads 5, but does not cover the small diameter wire portions of the bonding wires 6 (see Fig. 2). Although the thickness of the hardened silicone film 7 is 10 $\mu$m or less, preferably 7 to 8 $\mu$m in recessed portions thereof and 1 to 2 $\mu$m in protrud-

ing portions thereof (such condition is not expressed in the figure) owing to the uneven surface of the semiconductor chip 3 caused by the presence of circuit elements, the surface of the cured silicone film is even. The thermoset resin 8 (Fig. 1) is an epoxy resin in this example, but may be another thermoset resin such as a silicone resin.

The function of this example will now be described. Integrated sealing of the semiconductor chip, the bonding wires and the lead frame is effected by casting a high temperature thermosetting resin 8. A thermal shock in this step causes the semiconductor chip, the bonding wires, the lead frame, and the thermosetting resin to expand. A stress is set up because of different thermal expansion coefficients of the respective materials, but is relaxed by the cured silicone film 7 to moderate the influence of the stress on the semiconductor chip 3. Further, such a stress does not cause breaking of the bonding wires 4 because the bonding wires 4 have no contact with the interface between the cured silicone film 7 and the thermoset resin 8. Even when the above-mentioned interface surrounds the nailheads 5 as shown in Fig. 2, the nailheads can sufficiently resist the stress set up in the interface since the diameter of the nailhead portions 5 is large. Thus, the resin-sealed semiconductor device of the example can be freed from wire breaking induced by heat shock.

Since the thickness of the cured silicone film 7 can be as small as about 8 $\mu$m, the present invention can apply to a thin semiconductor device. A thin semiconductor device having a cured silicone film 7 of about 8 $\mu$m in thickness undergoes a smaller stress attributed to a sealing resin than that in a conventional counterpart device so that cracking in a protective film provided on a surface of a semiconductor chip and made of, for example, phosphorus glass can be avoided, thereby leading to an excellent moisture resistance of the device in cooperation with coverage of the bonding pads 4 with the cured silicone film 7.

As described above, according to the present invention, a cured silicone film 7 is formed in such a way that it covers surfaces of a semiconductor chip 3, bonding pads 4 and the nailhead portions 5 of said bonding wires 6, whereby breaking of the bonding wires 6 caused by stress set up upon infliction of a thermal shock on the device can be avoided. Since the surface of the semiconductor chip 3 is covered with the cured silicone film 7, the deterioration or corrosion of the surface portion of the semiconductor chip can be prevented, while the stress set up by expansion or shrinkage of the sealing resin 8 caused by a temperature change is relaxed to minimize the influence of the stress on the semiconductor chip, thereby preventing peeling of a circuit pattern and/or separation of bonded nailheads from the pads 4. Further, since the cured silicone film 7 can be formed to be thin, the present invention can apply to a thin semiconductor device. A thin semiconductor device having a thin cured silicone film 7 undergoes a smaller stress attributed to a sealing resin 8 than that in a conventional counterpart device so that cracking in a protective film provided on the surface of a semiconductor chip and made of, for example, phosphorus glass can be avoided, thereby leading to excellent moisture resistance of the device. This enables the surface mounting method to be adopted for attaining high density mounting on a printed circuit board.

## Claims

1. A resin-sealed semiconductor device comprising a semiconductor chip having thereon bonding pads electrically connected with a lead frame by bonding wires and having a surface thereof covered with a cured silicone film, characterised by the fact that said cured silicone film (7) is composed of a cured silicone rubber or a cured silicone gel, that said film (7) has a thickness of 10 $\mu$m or less, and that said film (7) integratedly covers only said surface of said semiconductor chip (3), said bonding pads (4) and the nailhead portions (5) of said bonding wires (6).

2. A resin-sealed semiconductor device as claimed in Claim 1, wherein said cured silicone film has a thickness of 7 to 8 $\mu$m in recessed surface portions of said semiconductor chip and a thickness of 1 to 2 $\mu$m in protruding portions of said semiconductor chip.

3. A resin-sealed semiconductor device as claimed in Claim 1 or 2, wherein the surface of said cured silicone film is even.

4. A resin-sealed semiconductor device as claimed in any of Claims 1 to 3, wherein said semiconductor chip is an LSI, a transistor, an IC, or a VLSI.

5. A resin-sealed semiconductor device as claimed in any of Claims 1 to 4, wherein said bonding pads (4) are composed of aluminum, and said bonding wires (6) are composed of gold or aluminum.

6. A resin-sealed semiconductor device as claimed in any of Claims 1 to 5, wherein said device is sealed within a thermosetting resin.

7. A resin-sealed semiconductor device as claimed in Claim 6, wherein said thermosetting resin is an epoxy resin.

## Revendications

1. Dispositif à semi-conducteur enrobé de résine, comprenant une microplaquette semi-conductrice portant des plots de liaison reliés électriquement à un cadre de montage par des fils métalliques de liaison et ayant une surface recouverte d'une pellicule silicone polymérisée, caractérisé en ce que ladite pellicule silicone polymérisée (7) est composée d'un caoutchouc silicone polymérisé ou d'un gel silicone polymérisé, ladite pellicule (7) ayant une épaisseur de 10 $\mu$m ou moins, et cette pellicule (7) recouvrant de façon intégrée seulement la surface de ladite microplaquette semi-conductrice (3), les plots de liaison (4) et les têtes d'épingles (5) des fils métalliques de liaison (6).

2. Dispositif à semi-conducteur enrobé de résine suivant la revendication 1, caractérisé en ce que la pellicule silicone polymérisée a une épaisseur de 7 à 8 $\mu$m dans des parties en creux de la surface de la microplaquette semi-conductrice, et une épaisseur de 1 à 2 $\mu$m dans les parties en saillies de ladite microplaquette.

3. Dispositif à semi-conducteur enrobé de résine suivant la revendication 1 ou 2, caractérisé en ce que la surface de la pellicule silicone polymérisée est unie.

4. Dispositif à semi-conducteur enrobé de résine suivant l'une quelconque des revendications 1 à 3, caractérisé en ce que la microplaquette semi-conductrice est une microplaquette à circuit intégré à grande échelle, un transistor, un circuit intégré, ou une microplaquette à très grande échelle.

5. Dispositif à semi-conducteur enrobé de résine suivant l'une quelconque des revendications 1 à 4, caractérisé en ce que les plots de liaison (4) sont en aluminium, et en ce que les fils métalliques de liaison (6) sont en or ou en aluminium.

6. Dispositif à semi-conducteur enrobé de résine suivant l'une quelconque des revendications 1 à 5, caractérisé en ce qu'il est enrobé dans une résine thermodurcissable.

7. Dispositif à semi-conducteur enrobé de résine suivant la revendication 6, caractérisé en ce que ladite résine thermodurcissable est une résine époxy.

## Patentansprüche

1. Mit Harz abgedichtete Halbleitervorrichtung, enthaltend einen Halbleiterchip mit darauf angeordneten Verbindungsschuhen, die über Verbindungsdrähte in elektrischer Verbindung mit einem Zuleitungsrahmen stehen, und mit einer Oberfläche, die mit einem gehärteten Siliconfilm bedeckt ist, **gekennzeichnet durch** die Tatsache, daß der gehärtete Siliconfilm (7) zusammengesetzt ist aus gehärtetem Siliconkautschuk oder gehärtetem Silicongel, wobei der Film (7) eine Dicke von 10 $\mu$m oder weniger aufweist und der Film (7) ganzheitlich nur die Oberfläche des Halbleiterchips (3), der Verbindungsschuhe (4) und der Nagelkopfteile (5) der Verbindungsdrähte (6) bedeckt.

2. Mit Harz abgedichtete Halbleitervorrichtung nach Anspruch 1, **dadurch gekennzeichnet,** daß der gehärtete Siliconfilm eine Dicke von 7-8 $\mu$m in zurückgesetzten Oberflächenteilen des Halbleiterchips und eine Dicke von 1-2 $\mu$m in vorspringenden Teilen des Halbleiterchips aufweist.

3. Mit Harz abgedichtete Halbleitervorrichtung nach Anspruch 1 oder 2, **dadurch gekennzeichnet,** daß die Oberfläche des gehärteten Siliconfilmes eben ist.

4. Mit Harz abgedichtete Halbleitervorrichtung nach jedem der Ansprüche 1-3, **dadurch gekennzeichnet,** daß der Halbleiterchip ein LSI, ein Transistor, ein IC oder ein VLSI ist.

5. Mit Harz abgedichtete Halbleitervorrichtung nach jedem der Ansprüche 1-4, **dadurch gekennzeichnet,** daß die Verbindungsschuhe (4) aus Aluminium und die Verbindungsdrähte (6) aus Gold oder Aluminium sind.

6. Mit Harz abgedichtete Halbleitervorrichtung nach jedem der Ansprüche 1-5, **dadurch gekennzeichnet,** daß die Vorrichtung mit einem wärmehärtenden Harz abgedichtet ist.

7. Mit Harz abgedichtete Halbleitervorrichtung nach Anspruch 6, **dadurch gekennzeichnet,** daß das wärmehärtende Harz ein Epoxyharz ist.

5

FIGURE 1

FIGURE 2

FIGURE 3